# EUROPEAN PATENT APPLICATION

(11) **EP 4 672 326 A1**
(43) Date of publication of application: **31.12.2025**
(21) Application number: 24760177.6
(22) Date of filing: 09.02.2024
(51) Int. Cl.: H01L 23/427, F28D 15/02

(54) **ELECTRONIC APPARATUS AND HEAT DISSIPATION DEVICE**

(30) Priority: 21.02.2023 JP 2023025543
(71) Applicant: Sony Interactive Entertainment Inc., Tokyo 108-0075 (JP)
(72) Inventor: TANIMOTO, Naoki, Tokyo 108-0075 (JP); TSUCHIDA, Shinya, Tokyo 108-0075 (JP); SASAKI, Chiyoshi, Tokyo 108-0075 (JP); TAMAKI, Yuta, Tokyo 108-0075 (JP); AOKI, Keiichi, Tokyo 108-0075 (JP)
(74) Representative: Fish & Richardson P.C.
(86) International application number: PCT/JP2024/004577
(87) International publication number: WO 2024/176875

(57) **Abstract**

There are provided an electronic apparatus and a heat dissipation device for improving the capacity to cool an IC chip. A heat dissipation device (100) has a plurality of heat pipes (130) that are arrayed along a surface (10D) of an IC chip (10) in the right-left direction and include a joining part (131) formed by joining together the heat pipes (130) adjacent to one another. A middle position (L1) of the joining part (131) in the right-left direction is shifted to a first side in the right-left direction with respect to a middle position (L2) of the surface 10D in the right-left direction.

## Description

### [Technical Field]

The present disclosure relates to an electronic apparatus and a heat dissipation device.

### [Background Art]

Recent years have seen the use of IC (integrated circuit) chips such as SoCs (System on a Chips) that integrate functions of a CPU (Central Processing Unit), I/O (Input/Output), and other features. Also, there are used heat dissipation devices each including a plurality of heat pipes and heat sinks for cooling the IC chip. The plurality of heat pipes are joined together in the width direction of each heat pie to form a joining part that may thermally be connected with a single IC chip.

### [Citation List]

### [Patent Literature]

[PTL 1]
JP 2018-148026A

### [Summary]

### [Technical Problem]

Given the need for cost reduction and miniaturization of equipment, it has been desired to provide a heat dissipation device having a small-sized cooling structure that offers a higher cooling capacity with higher efficiency.

An object of the present disclosure is to provide an electronic apparatus and a heat dissipation device for improving the capacity to cool an IC chip.

### [Solution to Problem]

An electronic apparatus according to the present disclosure includes an IC chip having a surface facing in a first direction and a plurality of heat pipes. The plurality of heat pipes are arrayed along the surface in a second direction intersecting the first direction and include a joining part formed by joining together the heat pipes adjacent to one another. The joining part is placed in the first direction with respect to the surface and is thermally connected with the surface. A middle position of the joining part in the second direction is shifted to a first side in the second direction with respect to a middle position of the surface in the second direction. This cam improve the capacity to cool the IC chip.

Further, a heat dissipation device according to the present disclosure is a heat dissipation device for covering a surface of an IC chip facing in a first direction. The heat dissipation device includes a plurality of heat pipes. The plurality of heat pipes are arrayed along the surface in a second direction intersecting the first direction and include a joining part formed by joining together the heat pipes adjacent to one another. The joining part is placed in the first direction with respect to the surface and is thermally connected with the surface. A middle position of the joining part in the second direction is shifted to a first side in the second direction with respect to a middle position of the surface in the second direction. This can improve the capacity to cool the IC chip.

Further, another electronic apparatus according to the present disclosure includes an IC chip having a surface facing in a first direction and a plurality of heat pipes. The plurality of heat pipes are arrayed along the surface in a second direction intersecting the first direction and include a joining part formed by joining together the heat pipes adjacent to one another. The joining part is placed in the first direction with respect to the surface and is thermally connected with the surface. The heat absorption efficiency of the joining part in a region on a first side with respect to a middle position of the surface in the second direction is higher than the heat absorption efficiency of the joining part in a region on a second side with respect to the middle position. This can improve the capacity to cool the IC chip.

Further, another heat dissipation device according to the present disclosure is a heat dissipation device for covering a surface of an IC chip facing in a first direction. The heat dissipation device includes a plurality of heat pipes. The plurality of heat pipes are arrayed along the surface in a second direction intersecting the first direction and include a joining part formed by joining together the heat pipes adjacent to one another. The joining part is placed in the first direction with respect to the surface and is thermally connected with the surface. The heat absorption efficiency of the joining part in a region on a first side with respect to a middle position of the surface in the second direction is higher than the heat absorption efficiency of the joining part in a region on a second side with respect to the middle position. This can improve the capacity to cool the IC chip.

### [Brief Description of Drawings]

[FIG. 1]

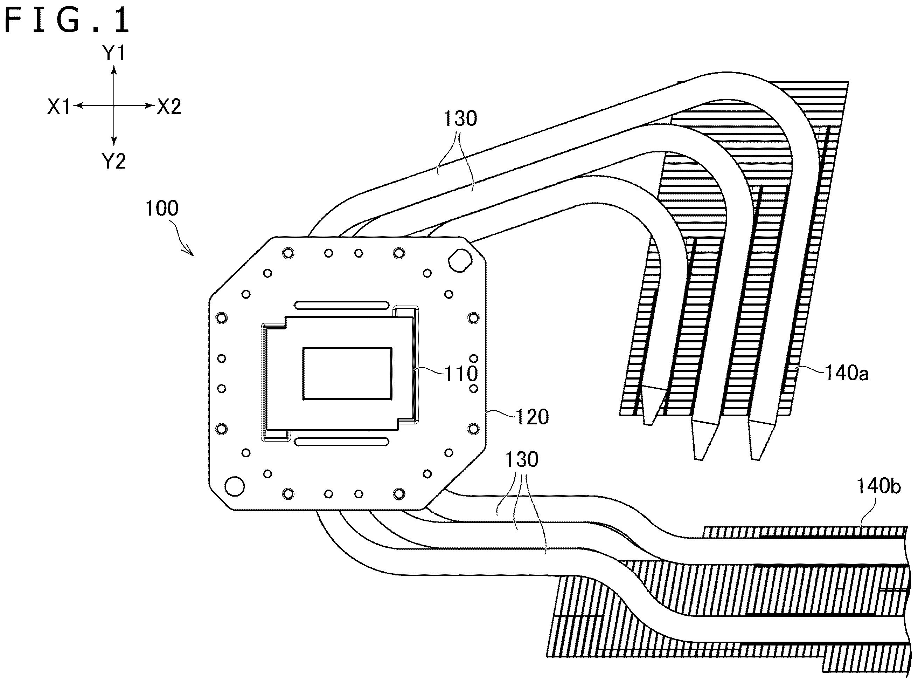

   FIG. 1 is a plan view of a heat dissipation device incorporated in an electronic apparatus according to one embodiment of the present disclosure.
[FIG. 2]

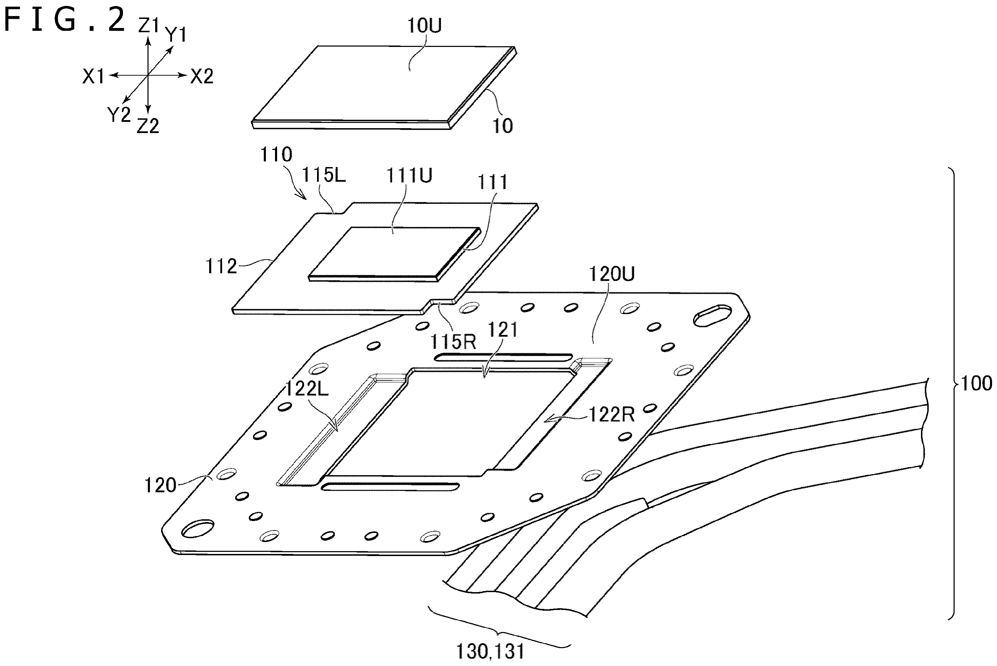

   FIG. 2 is an exploded perspective view of an IC chip incorporated in the electronic apparatus and constituent elements of the heat dissipation device.
[FIG. 3]

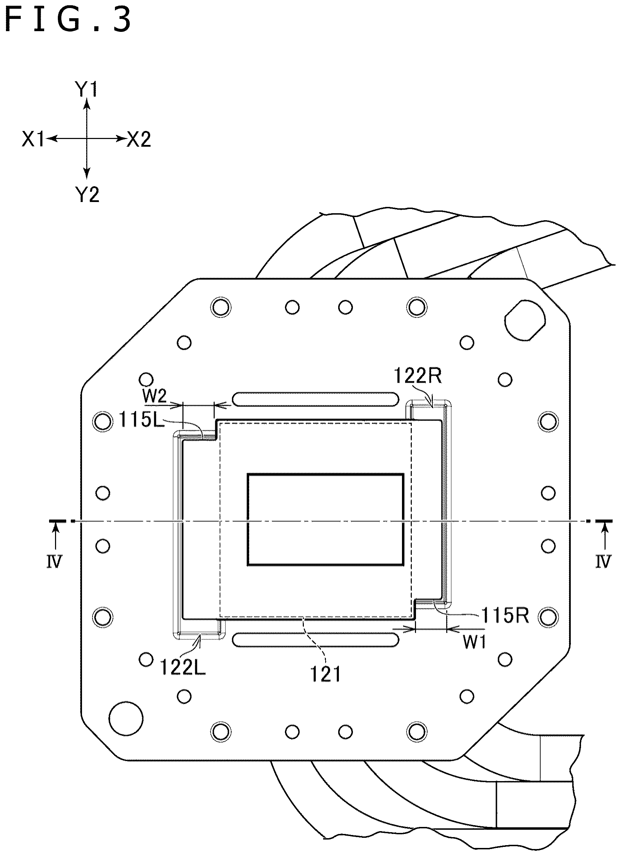

   FIG. 3 is a plan view of the heat dissipation device.
[FIG. 4]

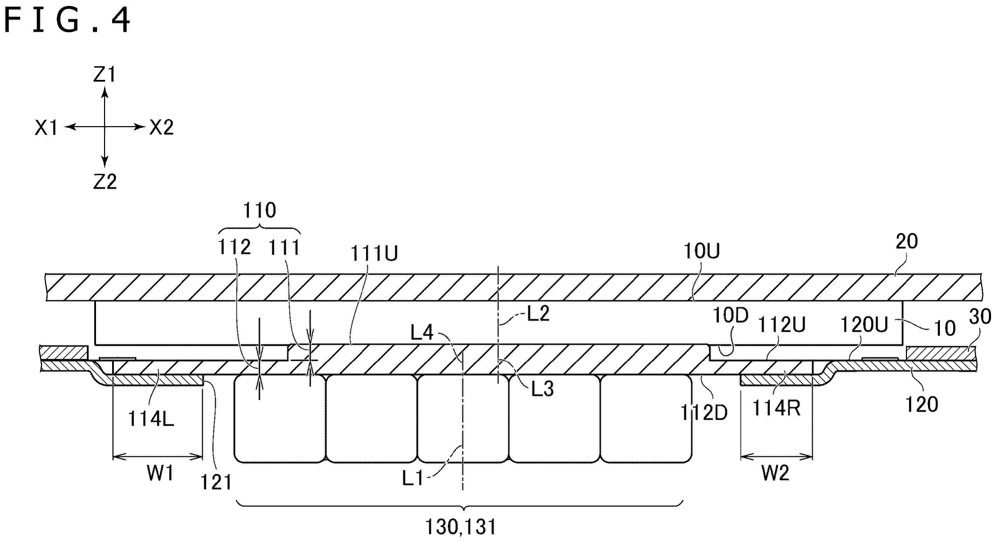

   FIG. 4 is a cross-sectional view of the IC chip and the heat dissipation device taken along a line IV-IV of FIG. 3.
[FIG. 5]

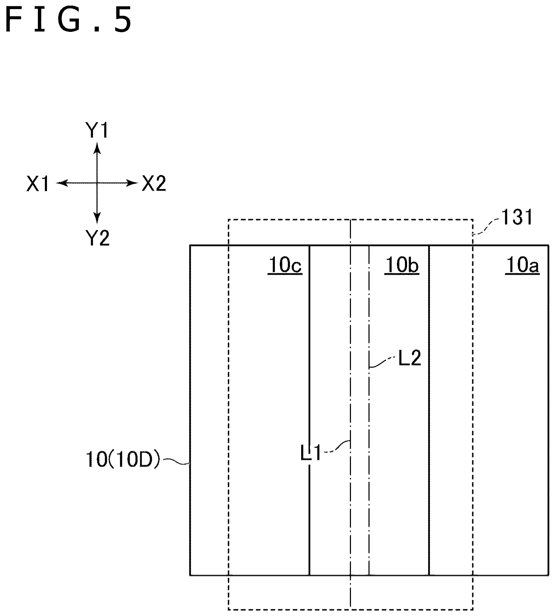

   FIG. 5 is a plan view schematically depicting exemplary regions of the respective functions mounted on a surface of the IC chip and an exemplary placement position of a joining part of heat pipes.
[FIG. 6]

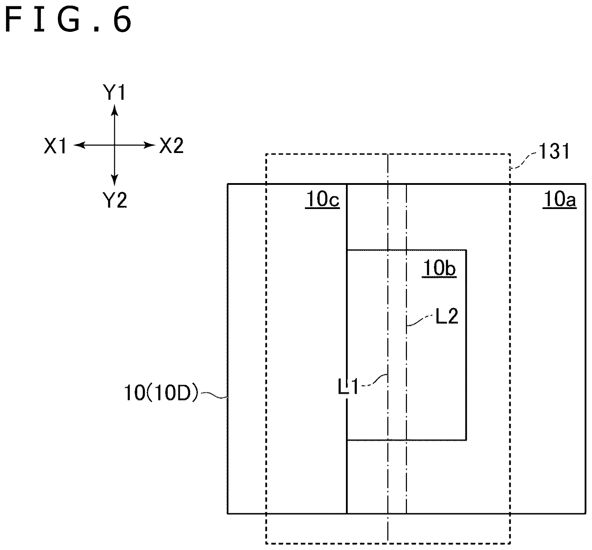

   FIG. 6 is a plan view schematically depicting other exemplary regions of the respective functions mounted on the surface of the IC chip and another exemplary placement position of the joining part of the heat pipes.
[FIG. 7]

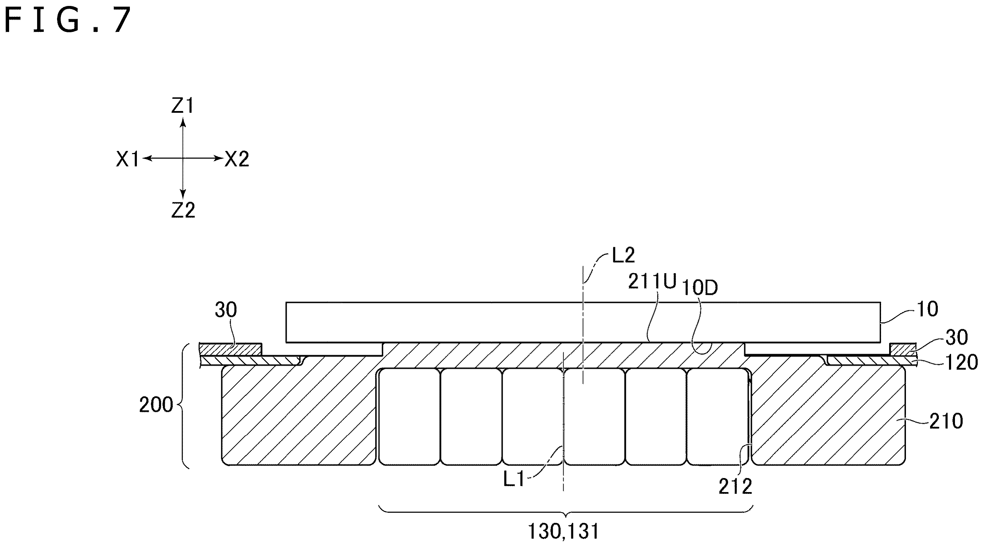

   FIG. 7 is a cross-sectional view of a heat dissipation device incorporated in an electronic apparatus according to another embodiment of the present disclosure.
[FIG. 8]

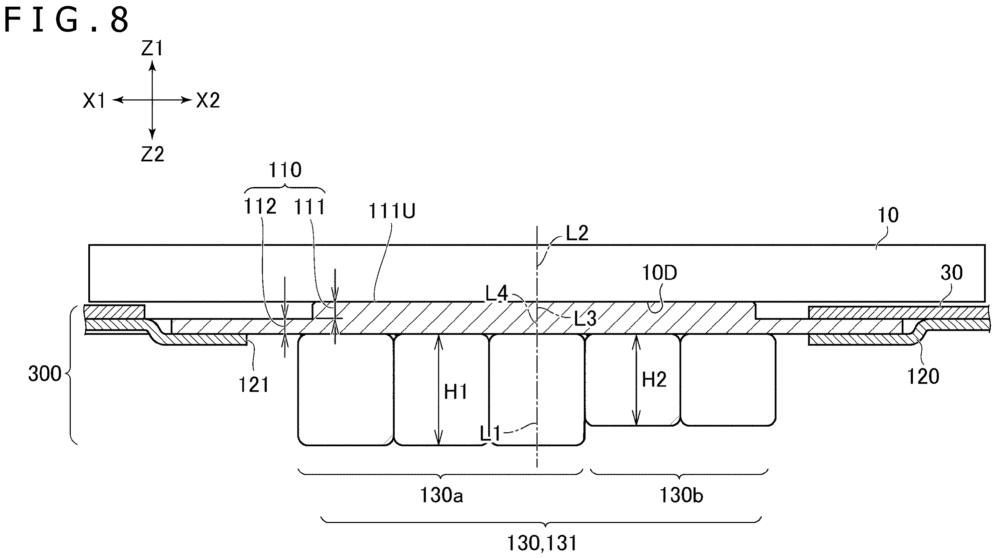

   FIG. 8 is a cross-sectional view of a heat dissipation device incorporated in an electronic apparatus according to another embodiment of the present disclosure.

### [Description of Embodiments]

### [1. Overview of the IC chip and the heat dissipation device]

FIG. 1 is a plan view of a heat dissipation device 100 incorporated in an electronic apparatus. FIG. 2 is an exploded perspective view of an IC chip 10 incorporated in the electronic apparatus and constituent elements of the heat dissipation device 100. FIG. 3 is a plan view of the heat dissipation device 100 in which a base plate 120 to be described later is depicted in an enlarged manner. FIG. 4 is a cross-sectional view of the IC chip 10 and the heat dissipation device 100 taken along the line IV-IV of FIG. 3.

In the following description, a Z1 direction and a Z2 direction along a Z-axis indicated in FIG. 2 and other figures will be referred to as the upward direction and the downward direction, respectively. In addition, an X1 direction and an X2 direction along an X-axis perpendicular to the Z-axis will be referred to as the leftward direction and the rightward direction, respectively. Moreover, a Y1 direction and a Y2 direction along a Y-axis perpendicular to the Z- and X-axes will be referred to as the forward direction and the backward direction, respectively. It is to be noted that these directions are defined only for the purpose of explaining the shapes of such elements as components, members, and portions of the heat dissipation device 100 as well as relative positional relations between the IC chip 10 and the heat dissipation device 100, for example, and do not limit the postures of the IC chip 10 and the heat dissipation device 100 in the electronic apparatus. For example, the electronic apparatus incorporating the IC chip 10 and the heat dissipation device 100 may be placed upside down on an installation surface such as a floor. Alternatively, the electronic apparatus may be placed with its side surface (i.e., surface in the X- or Y-axis direction) touching the installation surface.

The IC chip 10 is, for example, an SoC that integrates functions of a GPU (Graphics Processing Unit), a CPU, and I/O. The IC chip 10 may also include a function of a memory such as a ROM (Read Only Memory) or a RAM (Random Access Memory). In the present disclosure, the IC chip 10 is a flat plate-like semiconductor formed of silicon or the like, which is called a die. The IC chip 10 may incorporate circuits for implementing the functions of the GPU and other features. As indicated in FIGS. 2 and 4, the IC chip 10 has a flat plate-like shape and includes an upper surface 10U facing upward and a lower surface 10D (surface) facing downward (first direction). When the IC chip 10 is driven, a portion of the IC chip 10 that includes at least the lower surface 10D emits heat. In the following description, the lower surface 10D of the IC chip 10 will also be referred to as the heat-emitting surface 10D.

As depicted in FIG. 4, the IC chip 10 is mounted on a circuit board 20. The circuit board 20 is omitted from the illustrations in FIGS. 1 and 2. The circuit board 20 may be covered by a circuit board shield 30 formed of a conductive material such as iron or aluminum. In this case, the circuit board shield 30 may have an opening formed at the position of the IC chip 10 in such a manner as to expose the heat-emitting surface 10D. The heat dissipation device 100 for cooling the IC chip 10 may be attached at the position of the opening of the circuit board shield 30. The heat dissipation device 100 is placed on the lower side (in the direction indicated by Z2 in FIG. 2) of the IC chip 10 covered by the circuit board shield 30.

As depicted in FIGS. 1 and 2, the heat dissipation device 100 has a heat-receiving plate 110 (heat-receiving member), a base plate 120, a plurality of heat pipes 130 (six heat pipes 130 in this embodiment, as depicted in FIG. 4), a heat sink 140a, and a heat sink 140b. The heat-receiving plate 110, the plurality of heat pipes 130, and the heat sinks 140a and 140b are each formed of metal to cool the IC chip 10. The heat-receiving plate 110, the plurality of het pipes 130, and the heat sinks 140a and 140b may be formed of a metal of high thermal conductivity, such as aluminum or copper, or may alternatively be formed of iron. The base plate 120 may also be formed of a conductive material such as iron or aluminum.

As depicted in FIG. 2, the base plate 120 has an opening 121 at its center. In planar view of the circuit board unit, the opening of the base plate 120 is formed at the position of the IC chip 10. Also, as indicated in FIG. 2, a first contact part 111 is formed on the heat-receiving plate 110 in such a manner as to protrude upward (Z1 direction in FIG. 2). The top of the first connection part 111 constitutes a heat-receiving surface 111U coming into contact with the heat-emitting surface 10D of the IC chip 10 (see FIG. 4). The heat-emitting surface 10D may be coated with grease or a liquid metal for transmitting heat to the heat-receiving surface 111U. As depicted in FIGS. 1 and 2, in the heat dissipation device 100, the heat-receiving surface 111U of the heat-receiving plate 110 is exposed in the upward direction.

As depicted in FIG. 4, the plurality of heat pipes 130 are arrayed in the right-left direction (second direction intersecting the first direction, i.e., X-axis direction in FIG. 4) along the heat-emitting surface 10D of the IC chip 10, and include a joining part 131 formed by jointing together the heat pipes 130 adjacent to one another. The joining part 131 may be a part where all the plurality of heat pipes 130 (five heat pipes in this embodiment) included in the heat dissipation device 100 are joined together. The joining part 131 may be a part where the plurality of heat pipes 130 are welded or jointed together by fixing means such as soldering.

As depicted in FIG. 4, the joining part 131 of the heat pipes 130 is placed under the heat-emitting surface 10D of the IC chip 10 (in the first direction) and is thermally connected with the heat-emitting surface 10D of the IC chip 10. Here, the thermal connection means that the joining part 131 is in either direct or indirect contact with the heat-emitting surface 10D. The indirect contact means, for example, that grease, a liquid metal, or a metal layer is interposed between the joining part 131 and the heat-emitting surface 10D in such a manner that they are in contact with each other. In the example indicated in FIG. 4, the heat-receiving plate 110 is interposed between the joining part 131 and the heat-emitting surface 10D. In the opening 121 of the base plate 120, the heat-receiving plate 110 is in contact with both the heat-emitting surface 10D of the IC chip 10 and the joining part 131 of the heat pipes 130. The joining part 131 is in indirect contact with and is thermally connected with the heat-emitting surface 10D via the heat-receiving plate 110.

As depicted in FIG. 4, the heat-receiving plate 110 is interposed between the heat-emitting surface 10D of the IC chip 10 and the joining part 131 of the heat pipes 130 in the vertical direction (Z-axis direction). The heat-receiving plate 110 has the first connection part 111 that is in contact with and is thermally connected with the heat-emitting surface 10D. The heat-receiving plate 110 also has a second connection part 112 that is in contact with and is thermally connected with the joining part 131. More specifically, a lower surface 112D of the second connection part 112 is in contact with the joining part 131 of the heat pipes 130. The first connection part 111 protrudes upward from an upper surface 112U of the second connection part 112.

The heat pipes 130 transmit the heat of the IC chip 10 received via the heat-receiving plate 110 to the heat sink 140a or 140b depicted in FIG. 1. The heat sinks 140a and 140b release the heat of the IC chip 10 transmitted via the heat pipes 130. This enables the heat dissipation device 100 to cool the IC chip 10 in contact with the heat-receiving surface 111U.

The heat-receiving plate 110 is fixed to the base plate 120 by fixing means such as soldering. As depicted in FIG. 4, the heat-receiving plate 110 has a fixed part 114L positioned on the left side (X1 side) of the first connection part 111 and a fixed part 114R positioned on the right side (X2 side) of the first connection part 111. The fixed parts 114L and 114R are provided on a lower surface of the heat-receiving plate 110 (lower surface 112D of the second connection part 112). The fixed parts 114L and 114R are fixed to the base plate 120 by fixing means such as soldering.

### [2. Placement position of the joining part with respect to the IC chip]

FIG. 5 is a plan view schematically depicting exemplary regions of the respective functions mounted on the IC chip 10 and an exemplary placement position of the joining part 131 of the heat pipes 130 on the heat-emitting surface 10D. FIG. 6 is a plan view schematically depicting other exemplary regions of the respective functions mounted on the IC chip 10 and another exemplary placement position of the joining part 131 on the heat-emitting surface 10D. In each of the examples in FIGS. 5 and 6, a middle position L1 of the joining part 131 in the right-left direction (second direction) is shifted to a first side (left side (X1 side) in the examples in FIGS. 5 and 6) in the right-left direction with respect to a middle position L2 of the heat-emitting surface 10D in the right-left direction. The middle position L1 of the joining part 131 is the middle position, in the right-left direction, of all the heat pipes 130 positioned under the IC chip 10. With this, the heat absorption efficiency of the joining part 131 on the first side (e.g., left side) with respect to the middle position L2 of the heat-emitting surface 10D in the right-left direction becomes higher than the heat absorption efficiency of the joining part 131 on the second side (right side (X2 side) in the examples in FIGS. 5 and 6) with respect to the middle position L2. Incidentally, the "heat absorption efficiency" refers to an extent to which the heat on the heat-emitting surface 10D can be absorbed. For example, the heat absorption efficiency may be restated as the "amount of heat absorption" or the "heat transfer coefficient."

In the examples depicted in FIGS. 5 and 6, the middle position L1 of the joining part 131 is shifted to the left side (X1 side) with respect to the middle position L2 of the heat-emitting surface 10D in the right-left direction. With this, the heat absorption efficiency of the joining part 131 in regions (e.g., CP region 10c to be described later) on the left side with respect to the middle position L2 of the heat-emitting surface 10D becomes higher than the heat absorption efficiency of the joining part 131 in regions (e.g., I/O region 10a to be described later) on the right side with respect to the middle position L2 of the heat-emitting surface 10D. In this manner, the heat emitted from the heat-emitting surface 10D can be absorbed efficiently.

As depicted in FIGS. 5 and 6, the IC chip 10 includes the I/O region 10a (first region) in which circuits for performing a data input/output processing function are mounted, a GP region 10b (second region) for performing a first arithmetic processing function for parallel arithmetic processing, and the CP region 10c (third region) for performing a second arithmetic processing function. The "parallel arithmetic processing" is, for example, pipeline processing for executing a plurality of pieces of processing (e.g., instruction fetch and decoding) in parallel or data parallel processing which is implemented by executing the same processing on different portions of data. Further, the "first arithmetic processing function" is, for example, a function for image processing (arithmetic processing necessary for rendering images), machine learning processing such as deep learning, or other processing. The "second arithmetic processing function" is a function for general arithmetic processing different from the image processing and the machine learning processing. The GP region 10b primarily has the GPU function, while the CP region 10c principally has the CPU function. The temperature on the surface (heat-emitting surface 10D) of the IC chip 10 differs depending on the details of processing executed by each of the above-described regions.

In the GP region 10b (second region), M cores that perform the first arithmetic processing function for the image processing and the machine learning processing, for example, are mounted. Further, in the CP region 10c (third region), N (N < M) cores that perform the second arithmetic processing function for general arithmetic processing are mounted. The number of cores mounted in the GP region 10b is greater than the number of cores mounted in the CP region 10c.

The number of cores mounted in the GP region 10b is 50 or more, for example. The number of cores mounted in the GP region 10b may be 100 or more, or 200 or more. The number of cores mounted in the GP region 10b may be 500 or more, or 1,000 or more. By contrast, the number of cores mounted in the CP region 10c is 30 or less, for example. The number of cores mounted in the CP region 10c may be 20 or less, or 10 or less. The number of cores mounted in the CP region 10c may be five or less, or may be two or one.

When the IC chip 10 is driven (e.g., when the electronic apparatus is executing an application such as a game), the average temperature of a region is the highest in the GP region 10b followed by the CP region 10c and is the lowest in the I/O region 10a. The "average temperature" is an average of temperatures per unit area (e.g., 1 mm²) in each of the I/O region 10a, the GP region 10b, and the CP region 10c.

In the examples depicted in FIGS. 5 and 6, the CP region 10c, the GP region 10b, and the I/O region 10a are arrayed in this order from the first side to the second side (more specifically, from the left side (X1 side) to the right side (X2 side)) on the heat-emitting surface 10D. The GP region 10b is placed with a middle portion of the IC chip 10 included therein. The CP region 10c is placed on one side of the GP region 10b, and the I/O region 10a is placed on the other side of the GP region 10b. With this, the average temperature of the regions on the first side (e.g., left side) with respect to the middle position L2 of the heat-emitting surface 10D in the right-left direction (second direction) becomes higher than the average temperature of the regions on the second side (e.g., right side) with respect to the middle position of the heat-emitting surface 10D in the right-left direction. Meanwhile, the middle position L1 of the joining part 131 is shifted to the first side (e.g., left side) with respect to the middle position L2 of the heat-emitting surface 10D. This makes it possible to efficiently absorb the heat emitted from the heat-emitting surface 10D.

In the examples depicted in FIGS. 5 and 6, at least a portion of the I/O region 10a is placed on the right side (second side, i.e., the X2 side in FIGS. 5 and 6) with respect to the middle position L2 of the heat-emitting surface 10D in the right-left direction. In the example in FIG. 5, the whole I/O region 10a is placed on the right side with respect to the middle position L2 of the heat-emitting surface 10D. Further, in the example in FIG. 6, the I/O region 10a is placed on the right and left sides with respect to the middle position L2 of the heat-emitting surface 10D. In addition, in this example, one portion of the I/O region 10a on the right side (second side) with respect to the middle position L2 is larger in size than the other portion of the I/O region 10a on the left side (first side) with respect to the middle position L2 of the heat-emitting surface 10D. Meanwhile, the middle position L1 of the joining part 131 is shifted to the regions (on the left side with respect to the middle position L2 of the heat-emitting surface 10D) opposite to the right-side regions (on the right side with respect to the middle position L2 of the heat-emitting surface 10D) that cover extensively the I/O region 10 where the average temperature is the lowest. This makes it possible to efficiently absorb the heat emitted from the heat-emitting surface 10D.

In the examples depicted in FIGS. 5 and 6, the CP region 10c is placed on the left side (first side, i.e., the X1 side in FIGS. 5 and 6) with respect to the middle position L2 of the heat-emitting surface 10D in the right-left direction. More specifically, the entire CP region 10c is placed on the left side with respect to the middle position L2 of the heat-emitting surface 10D. Meanwhile, the middle position L1 of the joining part 131 is shifted to the regions on the left side with respect to the middle position L2 of the heat-emitting surface 10D, the regions including the CP region 10c. With respect to the middle position L2 of the heat-emitting surface 10D, the middle position L1 of the joining part 131 is shifted to the CP region 10c where the average temperature is higher than that in the I/O region 10a. This makes it possible to efficiently absorb the heat emitted from the heat-emitting surface 10D.

In the examples depicted in FIGS. 5 and 6, the GP region 10b is placed on the left side (first side, i.e., the X1 side in FIGS. 5 and 6) and on the right side (second side, i.e., the X2 side in FIGS. 5 and 6) with respect to the middle position L2 of the heat-emitting surface 10D. The middle position L1 of the joining part 131 in the right-left direction is placed in such a manner as to overlap with the GP region 10b where the average temperature is the highest when the IC chip 10 is driven (during execution of an application). The joining part 131 covers the entire GP region 10b. Further, the middle position L1 of the joining part 131 is interposed between the CP region 10c and the middle position L2 of the heat-emitting surface 10D in the right-left direction. In this way, the middle position L1 of the joining part 131 is placed in the GP region 10b and is shifted to the CP region 10c where the average temperature is the second highest after the GP region 10b. This makes it possible to efficiently absorb the heat emitted from the heat-emitting surface 10D.

As depicted in FIG. 4, the heat-receiving plate 110 has the first connection part 111 in contact with the heat-emitting surface 10D and the second connection part 112 in contact with the joining part 131. The first connection part 111 protrudes upward from the upper surface 112U of the second connection part 112. The width of the first connection part 111 in the right-left direction is smaller than the width of the second connection part 112 in the right-left direction.

As depicted in FIG. 4, a middle position L3 of the first connection part 111 in the right-left direction coincides with the middle position L2 of the heat-emitting surface 10D in the right-left direction. Further, a middle position L4 of the second connection part 112 in the right-left direction is shifted to the left side (first side, i.e., the X1 side in FIG. 4) with respect to the middle position L2 of the heat-emitting surface 10D. The middle position L4 of the second connection part 112 coincides with the middle position L1 of the joining part 131 in the right-left direction. On the heat-receiving plate 110, the middle position L3 of the first connection part 111 and the middle position L4 of the second connection part 112 are shifted in the right-left direction, as in the case of the middle position L2 of the heat-emitting surface 10D and the middle position L1 of the joining part 131. With this, after receiving the heat of the heat-emitting surface 10D on the heat-receiving surface 111U of the first connection part 111, the heat-receiving plate 110 can efficiently transmit the heat to the joining part 131 of the heat pipes 130.

As depicted in FIG. 2, on the left side (X1 side) and the right side (X2 side) of the base plate 120, recesses 122L and 122R are formed in such a manner as to be recessed downward with respect to an upper surface 120U of the base plate 120. As depicted in FIG. 4, the fixed parts 114L and 114R of the heat-receiving plate 110 are fixed to the inner sides of the recesses 122L and 122R of the base plate 120. As indicated in FIG. 4, the upper surface of the heat-receiving plate 110 (upper surface 112U of the second connection part 112) and the upper surface 120U of the base plate 120 are arranged in the same position in the vertical direction.

As depicted in FIGS. 2 and 3, on the heat-receiving plate 110, a cutout 115L is formed at the front end (end on the Y1 side) of the fixed part 114L on the left. At the back end (end on the Y2 side) of the fixed part 114R on the right, the width of the left-side cutout 115L in the right-left direction (X-axis direction) is different from the width of a right-side cutout 115R in the right-left direction. The width of the left-side cutout 115L in the right-left direction coincides with the width of the left-side recess 122L. The width of the right-side cutout 115R in the right-left direction coincides with the width of the right-side recess 122R.

The width of the right-side cutout 115R (width W1 of the right-side recess 122R in FIG. 4) of the heat-receiving plate 110 in the right-left direction is smaller than the width of the left-side cutout 115L (width W2 of the left-side recess 122L in FIG. 4) in the right-left direction. It is to be noted that the width W2 of the left-side cutout 115L (width W2 of the left-side recess 122L) of the heat-receiving plate 110 in the right-left direction may be smaller than the width of the right-side cutout 115R (width of the right-side recess 122R). In a case where the heat-receiving plate 110 is reversed in the right-left direction and in the front-back direction, the above arrangements prevent the heat-receiving plate 110 from being fitted into the recess 122L and 122R. That is, attaching of the heat-receiving plate 110 to the base plate 120 is not allowed with the heat-receiving plate 110 reversed in the right-left direction and the front-back direction. This can prevent the heat-receiving surface 111U of the base plate 120 from being displaced from its predesigned position. For example, in its position indicated in FIG. 4, the heat-receiving plate 110 can efficiently transmit, to the joining part 131 of the heat pipes 130, the heat of the heat-emitting surface 10D received by the heat-receiving surface 111U of the first connection part 111.

### [3. Modifications]

It is to be noted that the present invention is not limited to the above-described embodiment.

(1) FIG. 7 is a cross-sectional view of a heat dissipation device 200 incorporated in an electronic apparatus according to another embodiment of the present disclosure. As depicted in FIG. 7, the heat dissipation device 200 includes a heat-receiving block 210 as the heat-receiving member instead of the flat plate-like heat-receiving plate 110. A heat-receiving surface 211U at the top (top end) of the heat-receiving block 210 is in contact with the heat-emitting surface 10D of the IC chip 10.

As depicted in FIG. 7, a recess 212 is formed in a middle portion of a lower surface 210D of the heat-receiving block 210 in such a manner as to be recessed upward. The plurality of heat pipes 130 are fitted inside the recess 212. In such a manner, the plurality of heat pipes 130 fitted inside the recess 212 of the heat-receiving block 210 may constitute the joining part 131 arrayed in the right-left direction (X-axis direction, i.e., the second direction) along the heat-emitting surface 10D of the IC chip 10. Here, the width of the recess 212 in the right-left direction may coincide (or substantially coincide) with the width of the joining part 131 in the right-left direction.

It is to be noted that the number of heat pipes 130 constituting the joining part 131 may be five as depicted in FIG. 4, or six as depicted in FIG. 7. The middle position L1 of the joining part 131 is the middle position of all the heat pipes 130. Thus, in a case where there are six heat pipes 130 as indicated in FIG. 7, the middle position L1 is the middle position of the six heat pipes 130. The number of heat pipes 130 constituting the joining part 131 may be plural other than five or six.

Also in the example depicted in FIG. 7, the middle position L1 of the joining part 131 is shifted to the left side (X1 side) with respect to the middle position L2 of the heat-emitting surface 10D in the right-left direction. This allows the heat absorption efficiency in the CP region 10c (see FIGS. 5 and 6) and other regions on the left side with respect to the middle position L2 of the heat-emitting surface 10D to be higher than the heat absorption efficiency in the I/O region 10a (see FIGS. 5 and 6) and other regions on the right side (X2 side) with respect to the middle position L2 of the heat-emitting surface 10D. This makes it possible to efficiently absorb the heat emitted from the heat-emitting surface 10D.

(2) FIG. 8 is a cross-sectional view of a heat dissipation device 300 incorporated in an electronic apparatus according to another embodiment of the present disclosure. In the example depicted in FIG. 8, unlike the above-described heat dissipation device 100, the middle position L1 of the joining part 131 in the right-left direction (second direction) coincides with the middle position L2 of the heat-emitting surface 10D in the right-left direction. On the heat-receiving plate 110, the middle position L3 in the right-left direction of the first connection part 111 in contact with the heat-emitting surface 10D and the middle position L4 in the right-left direction of the second connection part 112 in contact with the joining part 131 also coincide with the middle position L2 of the heat-emitting surface 10D.

Also in the example depicted in FIG. 8, the heat absorption efficiency of the joining part 131 in the regions on the left side (first side, i.e., the X1 side in FIG. 8) with respect to the middle position L2 of the heat-emitting surface 10D in the right-left direction is higher than the heat absorption efficiency of the joining part 131 in the regions on the right side (second side, i.e., the X2 side in FIG. 8) with respect to the middle position L2. In the example in FIG. 8, five heat pipes arrayed in the right-left direction (X-axis direction) along the heat-emitting surface 10D of the IC chip 10 constitute the joining part 131, and three heat pipes 130a of the five heat pipes on the left side (X1 side) have higher thermal conductivity than two heat pipes 130b of the five heat pipes on the right side (X2 side).

For example, the heat pipes 130 (e.g., three heat pipes 130a) constituting the joining part 131 on the left side (X1 side) with respect to the middle position L2 of the heat-emitting surface 10D in the right-left direction may have a different cross-section structure from the heat pipes 130 (e.g., two heat pipes 130b) constituting the joining part 131 in the regions on the right side (X2 side) with respect to the middle position L2. Here, "having a different cross-section structure" means that the cross-sectional shapes, sizes, and internal structures of the heat pipes 130 are different. For example, the internal structure of the heat pipes 130a on the left side (X1 side) may be designed to provide higher thermal conductivity than the internal structure of the heat pipes 130b on the right side (X2 side).

In the example depicted in FIG. 8, the cross-sectional size (height H1 in the vertical direction (Z-axis direction)) of the three heat pipes 130a on the left side is greater than the cross-sectional size (height H2) of the two heat pipes 130b on the right side. The different cross-sectional sizes allow the heat absorption efficiency in the CP region 10c (see FIGS. 5 and 6) and other regions on the left side with respect to the middle position L2 of the heat-emitting surface 10D to be higher than the heat absorption efficiency in the I/O region 10a (see FIGS. 5 and 6) and other regions on the right side with respect to the middle position L2 of the heat-emitting surface 10D. This makes it possible to efficiently absorb the heat emitted from the heat-emitting surface 10D.

Further, the joining part 131 is not limited in configuration to the example in FIG. 8. In another example, the joining part 131 may be configured in such a manner that the thermal conductivity of the material forming the heat pipes 130a on the left side (X1 side) is made higher than the thermal conductivity of the material forming the heat pipes 130b on the right side (X2 side).

As another alternative, the heat exhaust efficiency (e.g., heat release amount proportional to the heat sink size) of the heat sink connected to the heat pipes 130a on the left side (X1 side) may be made higher than the heat exhaust efficiency of the heat sink connected to the heat pipes 130b on the right side (X2 side).

The above structures also allow the heat absorption efficiency on the left side (X1 side) with respect to the middle position L2 of the heat-emitting surface 10D to be higher than the heat absorption efficiency in the regions on the right side (X2 side) with respect to the middle position L2 of the heat-emitting surface 10D. This makes it possible to efficiently absorb the heat emitted from the heat-emitting surface 10D.

(3) In the above embodiment, as depicted in FIGS. 5 and 6, an example has been explained in which the heat-emitting surface 10D of the IC chip 10 includes the I/O region 10a, the GP region 10b, and the CP region 10c. However, the heat-emitting surface 10D of the IC chip 10 is not limited thereto and may include the I/O region 10a and the GP region 10b but exclude the CP region 10c. In this case, the GP region 10b may be placed on the first side (e.g., left side (X1 side)) with respect to the middle position L2 of the heat-emitting surface 10D, and the I/O region 10a may be placed on the second side (e.g., right side (X2 side)) with respect to the middle position L2 of the heat-emitting surface 10D.

As another alternative, the heat-emitting surface 10D may include the I/O region 10a and the CP region 10c but exclude the GP region 10b. In this case, the CP region 10c may be placed on the left side with respect to the middle position L2 of the heat-emitting surface 10D in the right-left direction, and the I/O region 10a may be placed on the right side with respect to the middle position L2 of the heat-emitting surface 10D.

Also in these structures, the middle position L1 of the joining part 131 in the right-left direction (see FIGS. 5 and 6) is shifted with respect to the middle position L2 of the heat-emitting surface 10D. This allows the heat absorption efficiency of the joining part 131 in the regions on the left side (X1 side in FIGS. 5 and 6) with respect to the middle position L2 of the heat-emitting surface 10D to be higher than the heat absorption efficiency in the regions on the right side (X2 side in FIGS. 5 and 6). This makes it possible to efficiently absorb the heat emitted from the heat-emitting surface 10D, which improves the capacity to cool the IC chip.

### [4. Summary]

(1) As discussed above, an electronic apparatus according to the present disclosure includes an IC chip having a heat-emitting surface facing in a first direction and a plurality of heat pipes. The plurality of heat pipes are arrayed along the heat-emitting surface in a second direction intersecting the first direction and include a joining part formed by joining together the heat pipes adjacent to one another. The joining part is placed in the first direction with respect to the heat-emitting surface and is thermally connected with the heat-emitting surface. A middle position of the joining part in the second direction is shifted to a first side in the second direction with respect to a middle position of the heat-emitting surface in the second direction. This can improve the capacity to cool the IC chip.
(9) A heat dissipation device according to the present disclosure is a heat dissipation device for covering a heat-emitting surface of an IC chip facing in a first direction. The heat dissipation device includes a plurality of heat pipes. The plurality of heat pipes are arrayed along the heat-emitting surface in a second direction intersecting the first direction and include a joining part formed by joining together the heat pipes adjacent to one another. The joining part is placed in the first direction with respect to the heat-emitting surface and is thermally connected with the heat-emitting surface. A middle position of the joining part in the second direction is shifted to a first side in the second direction with respect to a middle position of the heat-emitting surface in the second direction. This can improve the capacity to cool the IC chip.
(2) In the electronic apparatus according to (1) above, an average temperature of a region of the surface on the first side may be higher than an average temperature of a region of the surface on a second side with respect to the middle position of the surface in the second direction.
(3) In the electronic apparatus according to (1) or (2) above, the IC chip may include a first region in which a circuit for performing a data input/output processing function is formed. At least a portion of the first region may be placed on a second side with respect to the middle position of the surface in the second direction.
(4) In the electronic apparatus according to (3) above, the first region may be placed on the first side and the second side. A portion of the first region on the second side may be larger in size than the other portion of the first region on the first side.
(5) In the electronic apparatus according to any one of (1) through (4) above, the IC chip may include a second region and a third region, the second region having M cores mounted therein to perform a first arithmetic processing function for parallel arithmetic processing, the third region having N (N < M) cores mounted therein to perform a second arithmetic processing function. The third region may be placed on the first side.
(6) In the electronic apparatus according to (5) above, the middle position of the joining part in the second direction may be interposed between the third region and the middle position of the surface in the second direction.
(7) The electronic apparatus according to any one of (1) through (6) above may include a heat-receiving member interposed between the surface and the joining part. The heat-receiving member may have a first connection part that is in contact with the surface and is thermally connected with the surface, and a second connection part that is in contact with the joining part and is thermally connected with the joining part. A middle position of the first connection part in the second direction may coincide with the middle position of the surface in the second direction. A middle position of the second connection part in the second direction may be shifted to the first side with respect to the middle position of the surface in the second direction.
(8) In the electronic apparatus according to (7) above, the middle position of the second connection part in the second direction may coincide with the middle position of the joining part in the second direction.
(10) Another electronic apparatus according to the present disclosure includes an IC chip having a heat-emitting surface facing in a first direction and a plurality of heat pipes. The plurality of heat pipes are arrayed along the heat-emitting surface in a second direction intersecting the first direction and include a joining part formed by joining together the heat pipes adjacent to one another. The joining part is placed in the first direction with respect to the heat-emitting surface and is thermally connected with the heat-emitting surface. The heat absorption efficiency of the joining part on a first side with respect to a middle position of the heat-emitting surface in the second direction is higher than the heat absorption efficiency of the joining part in a region on a second side with respect to the middle position. This can improve the capacity to cool the IC chip.
(13) Another heat dissipation device according to the present disclosure is a heat dissipation device for covering a heat-emitting surface of an IC chip facing in a first direction. The heat dissipation device includes a plurality of heat pipes. The plurality of heat pipes are arrayed along the heat-emitting surface in a second direction intersecting the first direction and include a joining part formed by joining together the heat pipes adjacent to one another. The joining part is placed in the first direction with respect to the heat-emitting surface and is thermally connected with the heat-emitting surface. The heat absorption efficiency of the joining part on a first side with respect to a middle position of the heat-emitting surface in the second direction is higher than the heat absorption efficiency of the joining part on a second side with respect to the middle position. This can improve the capacity to cool the IC chip.
(11) In the electronic apparatus according to (10) above, a cross-section structure of the heat pipes constituting the joining part on the first side with respect to the middle position of the surface in the second direction may be different from a cross-section structure of the heat pipes constituting the joining part on the second side with respect to the middle position.
(12) In the electronic apparatus according to (10) or (11) above, the heat exhaust efficiency of a heat sink connected to the heat pipes constituting the joining part on the first side with respect to the middle position of the surface in the second direction may be higher than the heat exhaust efficiency of a heat sink connected to the heat pipes constituting the joining part on the second side with respect to the middle position.

## Claims

1. An electronic apparatus comprising:
an integrated circuit chip having a surface facing in a first direction; and
a plurality of heat pipes, wherein
the plurality of heat pipes are arrayed along the surface in a second direction intersecting the first direction and include a joining part formed by joining together the heat pipes adjacent to one another,
the joining part is placed in the first direction with respect to the surface and is thermally connected with the surface, and
a middle position of the joining part in the second direction is shifted to a first side in the second direction with respect to a middle position of the surface in the second direction.

2. The electronic apparatus according to claim 1, wherein an average temperature of a region of the surface on the first side is higher than an average temperature of a region of the surface on a second side with respect to the middle position of the surface in the second direction.

3. The electronic apparatus according to claim 1, wherein the integrated circuit chip includes a first region in which a circuit for performing a data input/output processing function is formed, and
at least a portion of the first region is placed on a second side with respect to the middle position of the surface in the second direction.

4. The electronic apparatus according to claim 3, wherein
the first region is placed on the first side and the second side, and
a portion of the first region on the second side is larger in size than another portion of the first region on the first side.

5. The electronic apparatus according to claim 1, wherein the integrated circuit chip includes a second region and a third region, the second region having M cores mounted therein to perform a first arithmetic processing function for parallel arithmetic processing, the third region having N (N < M) cores mounted therein to perform a second arithmetic processing function, and
the third region is placed on the first side.

6. The electronic apparatus according to claim 5, wherein the middle position of the joining part in the second direction is interposed between the third region and the middle position of the surface in the second direction.

7. The electronic apparatus according to claim 1, further comprising:
a heat-receiving member interposed between the surface and the joining part, wherein
the heat-receiving member has a first connection part that is in contact with the surface and is thermally connected with the surface, and a second connection part that is in contact with the joining part and is thermally connected with the joining part,
a middle position of the first connection part in the second direction coincides with the middle position of the surface in the second direction, and
a middle position of the second connection part in the second direction is shifted to the first side with respect to the middle position of the surface in the second direction.

8. The electronic apparatus according to claim 7, wherein the middle position of the second connection part in the second direction coincides with the middle position of the joining part in the second direction.

9. A heat dissipation device for covering a surface of an integrated circuit chip facing in a first direction, the heat dissipation device comprising:
a plurality of heat pipes, wherein
the plurality of heat pipes are arrayed along the surface in a second direction intersecting the first direction and include a joining part formed by joining together the heat pipes adjacent to one another,
the joining part is placed in the first direction with respect to the surface and is thermally connected with the surface, and
a middle position of the joining part in the second direction is shifted to a first side in the second direction with respect to a middle position of the surface in the second direction.

10. An electronic apparatus comprising:
an integrated circuit chip having a surface facing in a first direction; and
a plurality of heat pipes, wherein
the plurality of heat pipes are arrayed along the surface in a second direction intersecting the first direction and include a joining part formed by joining together the heat pipes adjacent to one another,
the joining part is placed in the first direction with respect to the surface and is thermally connected with the surface, and
heat absorption efficiency of the joining part on a first side with respect to a middle position of the surface in the second direction is higher than heat absorption efficiency of the joining part on a second side with respect to the middle position.

11. The electronic apparatus according to claim 10, wherein a cross-section structure of the heat pipes constituting the joining part on the first side with respect to the middle position of the surface in the second direction is different from a cross-section structure of the heat pipes constituting the joining part on the second side with respect to the middle position.

12. The electronic apparatus according to claim 10, wherein heat exhaust efficiency of a heat sink connected to the heat pipes constituting the joining part on the first side with respect to the middle position of the surface in the second direction is higher than heat exhaust efficiency of a heat sink connected to the heat pipes constituting the joining part on the second side with respect to the middle position.

13. A heat dissipation device for covering a surface of an integrated circuit chip facing in a first direction, the heat dissipation device comprising:
a plurality of heat pipes, wherein
the plurality of heat pipes are arrayed along the surface in a second direction intersecting the first direction and include a joining part formed by joining together the heat pipes adjacent to one another,
the joining part is placed in the first direction with respect to the surface and is thermally connected with the surface, and
heat absorption efficiency of the joining part on a first side with respect to a middle position of the surface in the second direction is higher than heat absorption efficiency of the joining part on a second side with respect to the middle position.
